# EUROPEAN PATENT APPLICATION

(11) **EP 4 266 068 A1**
(43) Date of publication of application: **25.10.2023**
(21) Application number: 23164098.8
(22) Date of filing: 24.03.2023
(51) Int. Cl.: G01R 31/36, B60L 58/10, G01M 17/007

(54) **TEST BENCH AND TEST METHOD FOR VEHICLES WITH AN ELECTRIC MOTOR**

(30) Priority: 30.03.2022 ES 202230288
(71) Applicant: Seat, S.A., 08760 Martorell - Barcelona (ES)
(72) Inventor: GOMEZ VIA, David, 08760 MARTORELL, BARCELONA (ES); FERNANDEZ TORRES, Carlos, 08760 MARTORELL, BARCELONA (ES); BERNAL ARGÜELLES, Fernando, 08760 MARTORELL, BARCELONA (ES)
(74) Representative: Ponti & Partners, S.L.P

(57) **Abstract**

The present invention relates to a test bench for vehicles with an electric motor, where the test bench comprises a bench communication bus (Zb) configured to communicate bidirectionally with the internal communication bus (Zv) of the vehicle (V) and a control unit (UC) operatively connected to the bench communication bus (Zb), with the bench communication bus (Zb) and the control unit (UC) being configured to simulate and subject components (CH, CL) of the electrical systems of the vehicle (V) to given operating situations and/or to operating errors and test the responses emitted by the components (CH, CL) to the internal communication bus (Zv) of the vehicle (V).

The present invention also relates to a test method adapted to use the bench of the invention.

## Description

### Technical field

In a first aspect, the present invention relates to a test bench for vehicles with an electric motor, in particular for the components of the electrical systems of vehicles that include high-voltage and low-voltage systems.

A second aspect of the present invention relates to a test method adapted to use the bench of the first aspect.

### Prior state of the art

Test benches for vehicles with an electric motor comprising the features of the preamble of claim 1 of the present invention are known, that is, they are applied to vehicles of the type that comprise components that communicate with each other by means of an internal communication bus, for example, a CAN bus (Controller Area Network), where some of said components can be electrically powered with a high-voltage power supply system, including among such components an electric motor and a high-voltage battery.

Such is the case of the test bench described in document WO2021168756, which discloses a bench specially focused on testing the power or propulsion system of an electric vehicle, seeking to make a connecting box to intercalate between the power system, the power grid and the electric battery of the vehicle. However, the test bench proposed in said document does not test the behavior of other vehicle systems or components, nor in particular the behavior in the event of safety situations derived from operating errors such as electrical or other problems.

It is therefore necessary to offer an alternative to the state of the art that covers the gaps found in it, by providing a test bench that allows evaluating whether or not the electrical systems of an electric vehicle, and components thereof, are likely to generate dangerous situations for operators and developers, as well as for end users of the vehicles, in addition to checking whether the alarm and protection systems behave correctly.

### Description of the invention

To this end, in a first aspect, the present invention relates to a test bench for vehicles with an electric motor, said vehicles being of the type that comprise components that communicate with each other by means of an internal communication bus, where some of said components can be electrically powered with a high-voltage power supply system, including among such components an electric motor and a high-voltage battery.

Unlike test benches known in the state of the art, the test bench proposed by the first aspect of the present invention characteristically comprises a bench communication bus configured to communicate bidirectionally with the internal vehicle communication bus and a control unit, which generally includes a CPU (Central Processing Unit), and which is operatively connected to said bench communication bus, with the bench communication bus and the control unit being configured to simulate and subject said components to given operating situations and/or to operating errors and test the responses emitted by the components to the internal vehicle communication bus.

Thus, through the buses, that is, the bench bus and the vehicle bus, a message is interrupted and a new one is generated and input with a "false" parameter, in order to generate a virtual situation in the vehicle, that is, a situation which is not real but simulated by the test bench.

By means of the test bench of the first aspect of the present invention, according to its more generic definition set forth in the preceding paragraphs, and according to its different exemplary embodiments described below, it is possible to simulate and study the response of the different components of electrical systems of real vehicles, and of the electrical systems themselves, in different operating situations, for example dangerous situations which they may encounter, of both high-voltage systems and, preferably, low-voltage systems.

It is thereby possible to evaluate whether or not electrical systems and their components generate dangerous situations for operators and developers, as well as for end users of the vehicles, in addition to checking whether the alarm and protection systems arranged in the vehicle behave properly.

One of the technical effects obtained is, therefore, that of making it possible to evaluate in detail the safety of vehicles in dangerous situations, both in their manufacture and in their use, as well as the real behavior of alarm and protection systems. The proposed test bench makes it possible to evaluate the behavior of components of the vehicle, for the purpose of introducing minimal modifications or alterations to said vehicle, so that the simulated operating situations are as similar to the real operating situations of the vehicle.

Other technical effects obtained are those related to making it possible to evaluate the behavior of the components in other operating situations that are not necessarily dangerous situations, by subjecting them to given operating situations and/or operating errors that are not necessarily representative of dangerous situations.

The test bench proposed by the first aspect of the present invention for some exemplary embodiments that will be described below makes it possible to control the different electrical and electronic systems of the vehicle by sending different signals based on the different scenarios to be simulated, and thereby makes it possible to measure the variables, responses and measurements of the sensors of the vehicle or of the actual sensors of the test bench, in order to know whether or not its response is as expected.

According to an exemplary embodiment, the aforementioned operating errors include electrical problems (such as ground faults, short circuits, power outages, and electrical overloads) or mechanical problems (such as a cut in a cable, or a shock or impact).

For an exemplary embodiment, the test bench of the first aspect of the present invention comprises a first electrical wiring, which includes at least one first electrical bridge (for example, a relay, or another kind of switching device) that can be connected between a high-voltage power supply system and at least one of the components that can be electrically powered with the high-voltage power supply system.

For an implementation of said exemplary embodiment, the first electrical wiring, or high-voltage electrical wiring, comprises a plurality of first electrical bridges, where each of them can be electrically connected between the high-voltage power supply system and a respective one of the components that can be electrically powered with the high-voltage power supply system.

According to an exemplary embodiment, the test bench of the first aspect of the present invention comprises a high-voltage power supply, that is, of the aforementioned high-voltage power supply system that can be electrically connected through the aforementioned first electrical bridge, or first electrical bridges, to components that can be electrically powered with the high-voltage power supply system.

Alternatively, the power supply of the high-voltage power supply system is not comprised in the test bench, but rather is external to it.

For an exemplary embodiment, the control unit is operatively connected to the first electrical bridge, or first electrical bridges, and is configured to control it/them so that, for a given test, it bridges the high-voltage battery of the vehicle, providing power to the components that can be electrically powered with the high-voltage power supply system with the high-voltage power supply of the bench or with one external to same, and for a different test other than said given test, it does not bridge the high-voltage battery of the vehicle, with power being provided to the components that can be electrically powered with the high-voltage power supply system with the high-voltage battery of the vehicle. According to an exemplary embodiment, the first electrical wiring is bidirectional and is operatively connected to the control unit, the control unit being configured to control the first electrical bridge, or first electrical bridges, and/or the high-voltage power supply system, to generate at least part of the aforementioned given operating situations and/or operating errors to which the components that can be electrically powered with the high-voltage power supply system are subjected, including at least one of the following electrical problems: ground faults, short circuits, power outages, and electrical overloads.

According to an exemplary embodiment, the test bench of the first aspect of the present invention comprises a second electrical wiring, which includes at least one second electrical bridge (for example, a relay, or another kind of switching device) that can be connected between a low-voltage electrical power supply system and some of the components that can be electrically powered with a low-voltage power supply system, including among such components a low-voltage battery.

For an implementation of said exemplary embodiment, the second electrical wiring, or low-voltage electrical wiring, comprises a plurality of second electrical bridges, where each of them can be electrically connected between the low-voltage power supply system and a respective one of the components that can be electrically powered with the low-voltage power supply system.

According to an exemplary embodiment, the test bench of the first aspect of the present invention comprises a low-voltage power supply, that is, of the aforementioned low-voltage power supply system that can be electrically connected through the aforementioned second electrical bridge, or second electrical bridges, to components that can be electrically powered with the low-voltage power supply system.

Alternatively, the power supply of the low-voltage power supply system is not comprised in the test bench, but rather is external to it.

For an exemplary embodiment, the control unit is operatively connected to the second electrical bridge, or second electrical bridges, and is configured to control it/them so that, for a given test, it bridges the low-voltage battery of the vehicle, providing power to the components that can be electrically powered with the low-voltage power supply system with the low-voltage power supply of the bench or with one external to same, and for a different test other than said given test, it does not bridge the low-voltage battery of the vehicle, with power being provided to the components that can be electrically powered with the low-voltage power supply system with the low-voltage battery of the vehicle. For an exemplary embodiment, the test bench of the first aspect of the present invention comprises at least the following bench elements: the aforementioned control unit, the high-voltage power supply, the low-voltage power supply, a controller of the first and second electrical bridges which, for example, are arranged in a relay box, the controller being, for example, a PLC (Programmable Logic Controller).

According to an exemplary embodiment, the bench communication bus connects/communicates all the elements of the test bench of the first aspect of the present invention and allows messages to be exchanged between them.

Thus, according to an exemplary embodiment, the control unit controls the high- and low-voltage power supplies through the bench communication bus.

In an electric vehicle, each of the components of the high-voltage system has its own electronic control unit that controls the component. Such is the case of, for example, the following components: battery, compressor, heating system, electric motor, etc. According to an alternative embodiment, one and the same electronic control unit can control at least two components. The same occurs with the components of the low-voltage system.

Preferably, for the correct operation of the first and second electrical bridges, the respective components of the vehicle (the high-voltage components for the first bridges, and the low-voltage components for the second bridges) must be disconnected from each other and individually connected to the test bench. In particular, the high-voltage components must be individually disconnected from the high-voltage battery of the vehicle, the connection being made through the respective first electrical bridge. In turn, the low-voltage components can also be individually disconnected from the low-voltage battery of the vehicle, the connection being made through the respective second electrical bridge.

Thus, with regard to the high-voltage system, for example, the battery is disconnected from the compressor, individually connecting each of the components to the bench. In this way, the test bed of the first aspect of the present invention can control whether to electrically power the compressor individually with the power supply of the bench (if any), with an external one, with the battery of the vehicle, or whether to disconnect it. This is the case for each component, both high-voltage and low-voltage. This is controlled with a relay (or another kind of switching device), which connects/disconnects each component individually.

Therefore, for an exemplary embodiment, the bench has the control unit that sends messages through the bench bus, for example, to a PLC in the box with all the relays. For each test, each of the relays is activated/deactivated according to the test. The same occurs for the components of the low-voltage system.

According to an exemplary embodiment, the second electrical wiring is bidirectional and is operatively connected to the control unit, the control unit being configured to control the second electrical bridge, or second electrical bridges, and/or the low-voltage power supply system, to generate at least part of the aforementioned given operating situations and/or operating errors to which the components that can be electrically powered with the low-voltage power supply system are subjected, including at least one of the following electrical problems: ground faults, short circuits, power outages, and electrical overloads.

For an exemplary embodiment of the test bench of the first aspect of the present invention, the control unit is also configured to, by accessing the bench communication bus, modify or replace values of variables provided by at least part of the components to the internal vehicle communication bus, to simulate given operating situations of such components.

The vehicle bus is connected to the individual control units of each component to give instructions, read parameters, etc. Therefore, in order to generate a "false" situation, according to an exemplary embodiment, a message is input into the vehicle bus, as if it had been generated by the respective control unit of the component in question.

According to an exemplary embodiment, the test bench of the first aspect of the present invention comprises variable resistors that can be connected to the positive and negative poles of one or more components of the vehicle, the control unit being operatively connected to said variable resistors to modify and monitor its value through the bench communication bus, to generate and test at least part of the given operating situations to which the components are subjected. The objective of this exemplary embodiment is to test insulation faults (ground faults), and connection/disconnection, as well as to alter the resistance value of said variable resistors. Said variable resistors are controlled, for example, directly by the PLC of the relay box (or other switching devices), under the orders emitted by the control unit of the test bench.

According to an exemplary embodiment, the test bench of the first aspect of the present invention comprises an electrical actuator bridge configured to be electrically intercalated between electrical outlets of mechanical actuators of the vehicle, which are part of the mentioned components, and at least one electronic control unit of the vehicle that controls the operation of said mechanical actuators, the control unit being operatively connected to said electrical actuator bridge to supply to the electronic control unit, through same, electrical signals that simulate coming from the mechanical actuators, with values selected or modified according to given tests, to simulate operating situations and/or operating errors thereof.

For an exemplary embodiment, some of these actuators are connected to the test bench (therefore, their positive and negative poles are disconnected from the vehicle and directly connected to the test bench). They are generally actuators powered by the low-voltage system.

Thus, if, for an exemplary embodiment, the intention is to supplant the S&S (Start&Stop) button, which allows turning the vehicle or the fuses of the vehicle on/off, the test bench of the first aspect of the present invention makes it possible to simulate the interaction by the user, or a situation of disconnection of components by means of a fuse, which can be done in two ways:
- Simulating activation of the actuator (as if the user had turned the vehicle on), by means of the control unit of the bench, which activates the corresponding relay.
- A message or parameter can also be modified, being sent through the bus bench and bench of the vehicle to the control unit or electronic control unit of the S&S button, to simulate that the user has pressed it.

For an exemplary embodiment, the test bench of the first aspect of the present invention comprises one or more electrical charger(s) configured to be electrically connected to charging terminals of the battery of the vehicle, the control unit being operatively connected to the aforementioned electrical charger to control it to simulate different charging situations, according to given tests.

According to some exemplary embodiments, the first and/or second wiring comprise, in addition to the first and second electrical bridges, other electrical connections between the components of the high- and/or low-voltage system and the control unit of the test bench of the first aspect of the invention, to, for example, receive electrical signals from them or from sensors associated with them.

According to an exemplary embodiment, the test bench of the first aspect of the present invention comprises sensors, including voltage and/or current sensors, arranged in or electrically connected to the first and/or second electrical wiring, to measure electrical variables of the components, and/or temperature sensors configured and arranged to measure the temperature of the components.

The aforementioned sensors are arranged, depending on the exemplary embodiment, in the first and/or second electrical bridges, or in other points or sections of the first and/or second electrical wiring, such as in individual connections of the components.

For an implementation of said exemplary embodiment, the control unit is operatively connected to electrical outputs of said sensors, and configured to compare the values of electrical signals received through them, and which are related to the aforementioned electrical variables and/or temperature, with values also related to the electrical variables and/or temperature, but received through the bench communication bus.

According to an exemplary embodiment, the test bench of the first aspect of the present invention comprises, operatively connected to the control unit, detection means for detecting the physical reaction of the vehicle, in particular signals or alerts emitted by the vehicle when subjecting one or more of its components to any of the aforementioned given operating situations and/or operating errors, being configured to test the responses emitted by said component(s) when the control unit evaluates the detection signals generated by said detection means when detecting said signals or alerts.

For an implementation of said exemplary embodiment, the control unit is configured to carry out said evaluation by comparing the values of the detection signals with predefined values.

According to an implementation of said exemplary embodiment, the detection means are configured to detect audible signals or alerts (for example, an unfastened seat belt alarm, or an audible alert from the high-voltage system), and/or visual signals or alerts.

According to a variant of said implementation, the control unit is configured to generate and supply to the internal vehicle communication bus, through the bench communication bus, simulated values related to said electrical variables and/or temperature, to simulate said given operating situations to which the components can be subjected.

The test bench of the first aspect of the present invention thus constitutes a station, or another kind of installation, which makes it possible to test an electrical energy storage system (especially the high-voltage and low-voltage system) and the components associated with said electrical energy storage system of a vehicle. The test seeks to subject said components of the vehicle to all types of situations, which are simulated (short circuits, ground connections, accident, message errors, system disconnection, etc.) to evaluate that they behave correctly and do not generate dangerous situations for operators and developers (during development and testing phases) or for end users (making it possible to ensure a robust development of the system).

A second aspect of the present invention relates to a test method for vehicles with an electric motor, said vehicles being of the type that comprise components that communicate with each other by means of an internal communication bus, where some of said components can be electrically powered with a high-voltage power supply system, including among such components an electric motor and a high-voltage battery.

Unlike the test methods known in the state of the art, the test method proposed by the second aspect of the present invention comprises bidirectionally accessing an internal vehicle communication bus to:
- simulate and subject the mentioned components to given operating situations and/or operating errors; and
- test the responses emitted by the components to the internal vehicle communication bus.

According to some exemplary embodiments, the method proposed by the second aspect of the present invention comprises using the test bench according to any of its corresponding exemplary embodiments.

For an exemplary embodiment, the method proposed by the second aspect of the present invention comprises:
- simulating operating situations and/or operating errors of the components and/or different charging situations of the battery of the vehicle, according to given tests,
- test the responses emitted by the components to the internal vehicle communication bus, and/or values of measurements of electrical variables and/or temperature of the components, and
- compare said responses and/or values with reference parameters stored in the memory to evaluate the existence of possible anomalies.

As discussed, by means of the present invention, in its two aspects, the aim is to subject the high-voltage system of the vehicle and, optionally, also the low-voltage system, to a wide range of situations. In order to simulate the most realistic behavior possible, the present invention is preferably applied to a real vehicle (fully functional vehicle), with all the components and systems. In general, with the electronics of the vehicle being active, different situations are simulated by sending different signals from the test bench, in order to observe the reaction and response of the different electrification systems of the vehicle.

### Brief description of the drawings

The foregoing and other advantages and features will be more fully understood from the following detailed description of exemplary embodiments with reference to the accompanying drawings, which should be considered by way of illustration and not limitation, wherein:
Figure 1 is a block diagram that schematically shows the test bench proposed by the first aspect of the present invention connected to an electric vehicle, for an exemplary embodiment.
Figure 2 schematically shows the test bench of the present invention connected to a series of both high- and low-voltage components and elements of an electric vehicle, for an exemplary embodiment.
Figure 3 schematically shows part of the test bench of the present invention, in this case only elements applied to the high-voltage system, connected to a series of high-voltage components of an electric vehicle, for an exemplary embodiment.

### Detailed description of some exemplary embodiments

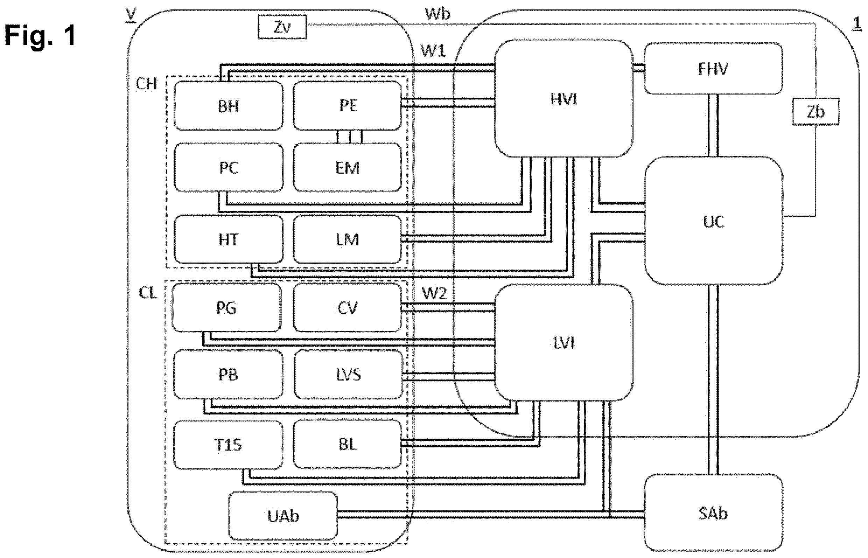

In Figure 1, blocks are used to illustrate the test bench 1 of the first aspect of the present invention which is connected to an electric vehicle V that includes a series of high-voltage components CH, that is, they can be electrically powered with a high-voltage power supply system, and a series of low-voltage components CL, that is, they can be electrically powered with a low-voltage power supply system. The components CL and CH of the electric vehicle V exchange information through an internal vehicle communication bus Zv (for example, CAN buses). In turn, the bench comprises its own bench bus Zb, operatively connected to the internal vehicle bus Zv, as will be explained in greater detail later. Through connection Wb and a series of electrical connections which are part of what is referred to in a previous section as the first electrical wiring W1 and second electrical wiring W2, an individual connection is made between components CH and CL and the test bench 1.

In particular, Figure 1 illustrates the test bench 1 connected to a vehicle V that includes the following high-voltage components CH: high-voltage battery BH, power electronics PE, electric motor EM, high-voltage charger PC, heater HT, climate control system components LM; and the following low-voltage components CL: gas pedal PG, brake pedal PB, DC-DC converter CV, 12V power supply LVS, 15/s terminal T15, low-voltage battery BL, and airbag control unit UAb. Each of the high-voltage components CH and low-voltage components CL is controlled by a respective electronic control unit. Said electronic control units are connected to each other and to other elements of the vehicle by means of the internal vehicle bus Zv, with information and control signals being exchanged to control the state of the respective components CH and CL.

In turn, the test bench 1 of the exemplary embodiment of Figure 1 comprises a control unit UC, and electrically and operatively connected to same, preferably bidirectionally, the bench communication bus Zb, a high-voltage power supply FHV, a high-voltage interface unit HVI, a low-voltage interface unit LVI, and an airbag impact unit SAb.

The interface units HVI, LVI are electrically connected to the high-voltage components CH and low-voltage components CL through the first electrical wiring W1 and second electrical wiring W2, respectively, which comprise a plurality of connections, including the previously described first and second electrical bridges (not illustrated in Figure 1).

The control unit UC simulates and subjects the components CH, CL to given operating situations and/or operating errors, and tests the responses emitted by the components CH, CL to the internal communication bus Zv of the vehicle V, and from this to the bench communication bus Zb, either by inputting simulated values of electrical signals in the bench communication bus Zb, or by electrically bridging the power supply of the components CH, CL, supplying it with power, in this case, from the high-voltage power supply FHV or from an external source (not illustrated), or otherwise, such as those described below in relation to the airbag impact unit SAb.

According to a first example, the control unit UC controls the electronic control unit associated with the electric motor EM of the electric vehicle V, which is in turn connected by means of the internal communication bus Zv of the vehicle V. In order to implement the simulations, the electric motor EM is disconnected from the high-voltage battery BH of the vehicle V and connected, by means of the first electrical wiring W1, to the high-voltage power supply system, in this case to the power supply FHV of the test bench 1. Said first electrical bridge allows the control unit UC of the test bench 1 to regulate whether the power supply of the electric motor EM is by means of said power supply FHV, or a power supply external to the test bench 1 (not depicted in the figures) or by means of the high-voltage battery BH, depending on the type of test to be carried out.

In another case, the control unit UC controls the airbag impact unit SAb, which is in turn connected to the airbag electronic control unit or control unit UAb of the vehicle V. To do this, said airbag impact unit SAb is disconnected from the vehicle V. It is removed from vehicle V and placed in a separate simulation unit, which comprises an actuator that turns the airbag impact unit SAb 180°. Additionally, an airbag impact electronic control unit UAb is partially connected to the vehicle V (for example, it is not connected to the pyrotechnic elements to make them explode, but it is connected to the bus ZV of the vehicle and the direct line from the pyrotechnic to the power supply battery). Additionally, the airbag impact electronic control unit UAb is connected by means of an electrical bridge to the test bench 1, being disconnected from the systems that power it from the vehicle V itself. Thus, when carrying out a test that simulates an impact, which is generated by turning the airbag impact unit SAb 180° by means of the turning actuator, the response of the rest of the components CH and CL of the vehicle is analyzed.

Thus, the test bench 1 makes it possible to know how the high-voltage power supply system responds to an impact situation. Additionally, the test bench 1 makes it possible to test for errors in the electrical power supply of the components and to see if the firing of the pyrotechnic elements would be activated, according to the information provided by the airbag impact electronic control unit UAb.

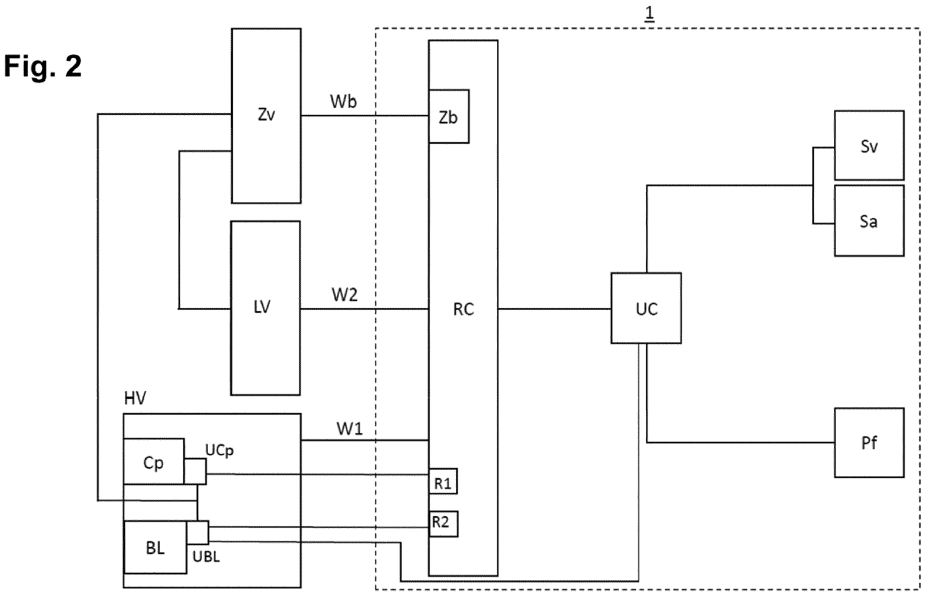

Figure 2 illustrates an exemplary embodiment for which the test bench 1 is connected to the low-voltage system LV (and therefore to the components thereof) of a vehicle (not illustrated), through the second wiring W2, and to the high voltage system HV, through the first wiring W1, with two high-voltage components of the high-voltage system HV being illustrated by way of example. The connection, through connection Wb, of the bench communication bus Zb to the internal vehicle communication bus Zv is also illustrated.

In this case, the test bench 1 includes the control unit UC, operatively connected to a unit RC, through which the high-voltage system HV and low-voltage system LV are electrically and operatively connected to the internal vehicle communication bus Zv.

The unit RC is a relay monitoring and control unit (or another type of switch that controls the state of the first and second electrical bridges) and cooperates with the control unit UC to carry out the functions of the test bench 1 explained above, according to some exemplary embodiments.

In particular, for the illustrated case, the unit RC includes relays R1, R2, which are part of the previously named first electrical bridge W1, and controls them to electrically bridge two respective high-voltage components of the vehicle, in this case a compressor Cp and a battery BH, which are electrically disconnected from each other to allow them to be bridged by test bench 1, in particular by relays R1 and R2, respectively, under the control of UC and RC. Thus, it is possible to manage that the high-voltage power supply of, for example, the Cp compressor may come, depending on the test to be implemented, from the battery BH (but through the first electrical bridge W1 and not directly), from the power supply FHV of the high-voltage system of the test bench 1 itself, or without powering said compressor Cp.

Both the compressor Cp and the battery BH include respective individual control units UCp and UBH, connected to the internal vehicle communication bus Zv. For the illustrated embodiment, the control unit UC of the test bench 1 can change operating parameters of the compressor Cp and the battery BH through the bus Zb and/or by accessing (access not illustrated) the individual control units UCp and UBH to handle them.

For a variant of the exemplary embodiment illustrated by Figure 2, the test bench 1 also includes relays (not shown) intended to make it possible to supplant mechanical actuators of the vehicle that are disconnected from the vehicle and connected directly to the test bench 1 (its positive and negative poles) when the corresponding relay is activated by the control unit UC.

In the exemplary embodiment illustrated in Figure 2, the battery BH is associated with a sensor SBH, for example a voltage, current or temperature sensor, connected to the control unit UC of the test bench 1, so that the latter can monitor the variable detected with the sensor SBH. Alternatively, the sensor SBH, or sensors, are included in the test bench 1 itself, and, in the case of being voltage or current sensors, indirectly connected to the corresponding component (either high-voltage component CH or low-voltage component CL) through the first wiring W1 or second wiring W2.

The test bench 1 of the exemplary embodiment of Figure 2 also includes, operatively connected to the control unit UC, a visual recognition system Sv and an audio recognition system Sa, the purpose of which is to detect visual and audible signals or alerts. respectively (for example, seat belt not fastened alarm, or high-voltage system acoustic alert) generated by the vehicle itself as a response to the given test generated by the test bench 1. Additionally, the test bench 1 also includes, operatively connected to the control unit UC, user input and data collection means Pf (such as a keyboard, touch screen, etc.) in order to be able to manually input particular operating conditions on the test bench 1.

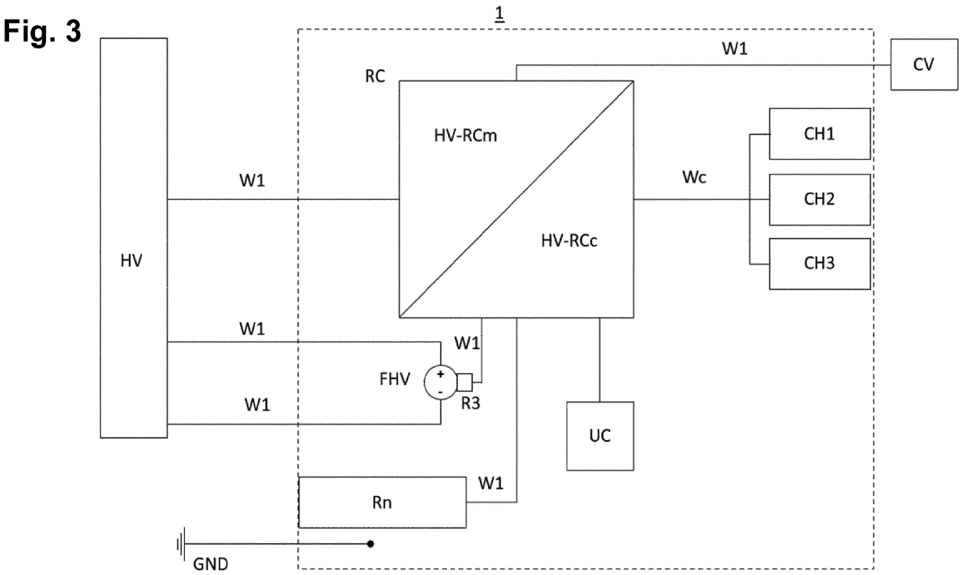

For an exemplary embodiment, Figure 3 illustrates part of the test bench 1, in this case the elements applied to the high-voltage system, connected to a high-voltage system HV of an electric vehicle, through a plurality of connections of the first electrical wiring W1. In this case, the bench communication bus Zb has not been shown, although it is present for its connection to the internal vehicle bus Zv (also not shown in this figure).

For the exemplary embodiment of Figure 3, the unit RC has been illustrated divided into two parts, one part for monitoring HV-RCm and one part for control HV-RCc, the first part monitoring the high-voltage components CH (not illustrated) of the high-voltage system HV of the vehicle, and the second part controlling relays, in this case R3 and Rn (shown by way of example), representative of the previously described first electrical bridges.

In particular, the relay R3 is controlled by control units UC and HV-RCc to connect/disconnect the high-voltage power supply FHV included in the test bench 1, which bridges the components of the high-voltage system HV connected to it through the two connections of the first electrical wiring W1 illustrated. The test bench 1 has a ground connection GND.

Reference Rn refers to a plurality of additional relays that can also be controlled by control units UC and HV-RCc to individually connect/disconnect each of the components that are connected to same, so that test bench 1 can control whether to electrically power the component individually with the power supply of the bench, with an external power supply, with the battery of vehicle, or whether to disconnect it.

In the test bench 1 of Figure 3, the monitoring unit HV-RCm is also connected, by means of a connection of the first electrical wiring W1, to a DC-DC converter CV of the vehicle, in order to monitor the loads to which it is subjected (caused by test bench 1 itself or not).

In turn, the test bench 1 in Figure 3 also comprises a series of electrical chargers, one with alternating current CH1 (single-phase and/or three-phase), another with direct current CH2, and another with double, alternating and continuous, output CH3, all of them connected to the control unit HV-RCc through connections of the first electrical wiring W1, in this case load connections. The purpose of these chargers CH1, CH2, CH3 is to be electrically connected to charging terminals of the battery of the vehicle, control units UC and HV-RCc being configured to control them to simulate different charging situations, such as a situation of charging the battery of the electric vehicle V, a suspension of a situation of charging, a discharge of the battery of the electric vehicle V to the power grid, etc., according to given tests.

After the explanation of the specific exemplary embodiments described above, it is therefore concluded that for the application of the test bench 1 of the present invention, at a general level, it is necessary to provide a vehicle with certain bidirectional connections with the test bench 1, and some of its particularities are as follows (depending on the exemplary embodiment, some will be present and others will not, or they will all be present):
- The vehicle electronics and systems are turned on.
- In order to know the behavior of these systems and also to be able to simulate certain parameters and situations, the test bench 1 is connected to the vehicle V by means of buses Zb and Zv (generally CAN buses). Thus, it is possible to read and modify parameters of interest, especially of the propulsion system, the battery system and the occupant comfort system. Thus, the bus Zv of the vehicle V is connected to an internal bus Zb of test bench 1, so that test bench 1 can read and write information, allowing bidirectional communication exchange between vehicle V and test bench 1.
- The high-voltage battery BH does not directly power vehicle systems, but is connected to the high-voltage system HV of the test bench 1 and connected back from this to the respective component CH of the vehicle V (indirect power supply). Electricity flows from the vehicle V to the test bench 1 and from the test bench 1 back to vehicle V. The test bench 1 makes it possible to monitor and generate deviations or failures or problems. Having this bridge makes it possible, in some of the tests, to replace the high-voltage battery BH with an external power supply or with a power supply FHV of the test bench 1 itself. As an example, it can be used in a particular test for an overload of the system HV, observing how the different systems of the vehicle behave. For this reason, the test bench 1 preferably has a power supply unit of up to 60V.
- The test bench 1 comprises a set of relays R1...Rn, which are activated or deactivated depending on the simulations to be carried out. Thus, through a relay, the battery of the vehicle V can be safely disconnected (sending messages to the internal bench bus Zb, which can obtain information from the vehicle bus Zv). The information of the vehicle V is analyzed when the connections and disconnections of the high-voltage system HV are made, in addition to information received from different sensors or detection devices available in the test bench 1 (voltmeter, ammeter, etc.). They make it possible to evaluate if the disconnection is safe and to proceed with the simulations.
- Not only is there a direct connection between the test bench 1 and the systems of the vehicle V through the respective buses Zb, Zv. Thus, other systems of the vehicle V are directly connected to the test bench 1 in order to be able to handle certain information. For example, there is the "resistance monitoring" function or test, where the test bench 1 makes it possible to modify the value of the resistance existing between different components CH, CL and the high-voltage system HV. This makes it possible to predict future short circuits or to simulate leaks. For example, a broken connector may have a lower resistance as a result of a blow, or because of a worn cable. Thus, in the connection of these systems (for example, the electric motor, the electronics unit, the heating electronic control unit of the battery, etc.), by intercalating a variable value resistor controlled by the test bench 1, it is possible to carry out this type of test. Therefore, the positives and negatives of all the high-voltage systems HV, also of the car chassis, are connected to the test bench 1, being derived to the test bench 1. Variable resistors are intercalated to be able to handle their value through the bench bus Zb.
- For the low-voltage system LV (12V battery) of the vehicle there are mechanisms similar to those associated with the high-voltage system HV. The low-voltage battery LV of the vehicle V is completely disconnected from the components to be powered, with the following two objectives: to be able to perform tests for a long time without the vehicle running out of low-voltage electrical power supply, and over and under load tests of the low-voltage power grid. For example, if there is no power supply, certain safety features still need to work.
- In the low-voltage system LV, the connections of buses Zb, Zv make it possible to handle digital values of certain variables read by the electronic control units of the vehicle V, such as messages about brake pressure, doors, windows, gears, etc. In this way, the test bench 1 transfers a digital value of a given variable directly to the vehicle V to be able to simulate a given situation.
- Moreover, there are other parameters where the electronic control units of the vehicle V directly read physical changes (for example, vehicle ignition button, seat position sensor, belt sensors, wiring of fuses to generate faults in the fuses, handbrake). All these components are directly connected to test bench 1 (they are again bridged). The test bench 1 directly replaces the signals from the mechanical actuators with their corresponding electrical variable, in order to also be able to simulate the conditions of variations in physical parameters without the need for a robot or manual actuation of said actuators of the vehicle V.
- Another embodiment of interest is the simulation of charging conditions of the batteries of the electric vehicle V, that is, those conditions in which the vehicle V is physically connected to a charger by means of a cable. A DC, single-phase AC and three-phase AC connection are available, depending on the exemplary embodiment, through the same connection to the test bench 1. Through the test bench 1, the one that will be supplied to the vehicle V to carry out the corresponding test is selected.

Thus, there are certain components, wiring, that are bridged in the test bench 1. The test bench 1 is made up of a number of relays (or other switching devices) that disconnect and connect the components of the vehicle with test bench 1, to generate the different scenarios in the vehicle and know their response. The control unit UC (or control units UC and SC) controls these relays based on the different scenarios to be simulated. Depending on the exemplary embodiment, the variables of the vehicle and/or the responses of the vehicle and/or the measurements of the sensors of the test bench 1 (or of the sensors of the vehicle) are measured, in order to determine whether or not the response of the vehicle to the different scenarios is as expected. Once a given test has been completed and it has been analyzed that the response of the vehicle V is as expected, the next test is automatically performed next, so that the control unit UC controls a new state of the relays R1...Rn and, consequently, of the components CH, CL of the vehicle V.

A person with average skill in the art could introduce changes and modifications in the exemplary embodiments described without departing from the scope of the invention as defined in the attached claims.

## Claims

1. A test bench (1) for vehicles with an electric motor, said vehicles (V) being of the type that comprise components (CH, CL) that communicate with each other by means of an internal communication bus (Zv), where some of said components (CH) can be electrically powered with a high-voltage power supply system, including among such components an electric motor (EM) and a high-voltage battery (BH), with the test bench (1) being **characterized in that** it comprises a bench communication bus (Zb) configured to communicate bidirectionally with the internal communication bus (Zv) of the vehicle (V) and a control unit (UC) operatively connected to said bench communication bus (Zb), with the bench communication bus (Zb) and the control unit (UC) being configured to simulate and subject said components (CH, CL) to given operating situations and/or to operating errors and test the responses emitted by the components (CH, CL) to the internal communication bus (Zv) of the vehicle (V).

2. The test bench (1) for vehicles with an electric motor according to claim 1, wherein said operating errors include electrical or mechanical problems.

3. The test bench (1) for vehicles with an electric motor according to claim 1, comprising a first electrical wiring (W1), which includes at least one first electrical bridge (R1, R2, R3, Rn) that can be connected between a high-voltage power supply system and at least one of said components (CH) that can be electrically powered with the high-voltage power supply system.

4. The test bench (1) for vehicles with an electric motor according to claim 3, comprising a power supply (FHV) of said high-voltage power supply system that can be electrically connected through said first electrical bridge (R3) to the components (CH) that can be electrically powered with the high-voltage power supply system.

5. The test bench (1) for vehicles with an electric motor according to claim 3 or 4, wherein the control unit (UC) is operatively connected to the at least one first electric bridge (R1, R2, R3, Rn) and is configured to control it so that, for a given test, it bridges the high-voltage battery (BH) of the vehicle (V), providing power to the components (CH) that can be electrically powered with the high-voltage power supply system with said power supply (FHV) of said high-voltage power supply system, or with a power supply external to the test bench (1), and for a different test other than said given test, it does not bridge the high-voltage battery (BH) of the vehicle (V), with power being provided to the components (CH) that can be electrically powered with the high-voltage power supply system with the high-voltage battery (BH) of the vehicle (V).

6. The test bench (1) for vehicles with an electric motor according to any one of claims 3 to 5, comprising a second electrical wiring (W2), which includes at least one second electrical bridge that can be connected between a low-voltage electrical power supply system and some of said components (CL), which can be electrically powered with a low-voltage power supply system, including among such components a low-voltage battery (BL).

7. The test bench (1) for vehicles with an electric motor according to claim 6, comprising a power supply of said low-voltage power supply system that can be electrically connected through said second electrical bridge to the components (CL) that can be electrically powered with the low-voltage power supply system.

8. The test bench (1) for vehicles with an electric motor according to claim 7, wherein the control unit (UC) is operatively connected to the at least one second electric bridge and is configured to control it so that, for a given test, it bridges the low-voltage battery (BL) of the vehicle (V), providing power to the components (CL) that can be electrically powered with the low-voltage power supply system with said power supply of said low-voltage power supply system, or with a power supply external to the test bench (1), and for a different test other than said given test, it does not bridge the low-voltage battery (BL) of the vehicle (V), with power being provided to the components (CL) that can be electrically powered with the low-voltage power supply system with the low-voltage battery (BL) of the vehicle (V).

9. The test bench (1) for vehicles with an electric motor according to any one of the preceding claims, wherein said control unit (UC) is also configured to, by accessing the bench communication bus (Zb), modify or replace values of variables provided by at least part of said components (CH, CL) to the internal vehicle communication bus (Zv), to simulate given operating situations of said components (CH, CL).

10. The test bench (1) for vehicles with an electric motor according to any of the preceding claims, comprising an electrical actuator bridge configured to be electrically intercalated between electrical outlets of mechanical actuators of the vehicle (V), which are part of said components (CH, CL), and at least one electronic control unit of the vehicle (V) that controls the operation of said mechanical actuators, the control unit (UC) being operatively connected to said electrical actuator bridge to supply to the electronic control unit, through same, electrical signals that simulate coming from the mechanical actuators, with values selected or modified according to given tests, to simulate operating situations and/or operating errors thereof.

11. The test bench (1) for vehicles with an electric motor according to any of claims 2 to 10, comprising sensors, including voltage and/or current sensors, arranged in or electrically connected to said first and/or second electrical wiring (W2), to measure electrical variables of the components (CH, CL), and/or temperature sensors configured and arranged to measure the temperature of the components (CH, CL).

12. The test bench (1) for vehicles with an electric motor according to claim 11, wherein the control unit (UC) is operatively connected to electrical outputs of said sensors, and configured to compare the values of electrical signals received through them, and which are related to said electrical variables and/or temperature, with values also related to said electrical variables and/or temperature, but received through the bench communication bus (Zb).

13. The test bench (1) for vehicles with an electric motor according to claim 12, wherein the control unit (UC) is configured to generate and supply to the internal communication bus (Zv) of the vehicle (V), through the bench communication bus (Zb), simulated values related to said electrical variables and/or temperature, to simulate said given operating situations to which the components (CH, CL) are subjected.

14. A test method for vehicles with an electric motor, said vehicles being of the type that comprise components (CH, CL) that communicate with each other by means of an internal communication bus (Zv), where some of said components (CH) can be electrically powered with a high-voltage power supply system, including among such components an electric motor (EM) and a high-voltage battery (BH), with the test method (1) being **characterized in that** it comprises bidirectionally accessing an internal communication bus (Zv) of the vehicle (V) to:
- simulate and subject said components (CH, CL) to given operating situations and/or operating errors; and
- test the responses emitted by the components (CH, CL) to the internal communication bus (Zv) of the vehicle (V).

15. The test method according to claim 14, which method comprises using the test bench according to any one of claims 1 to 13.
